## Europäisches Patentamt

## European Patent Office

## Office européen des brevets

(19)

(11) Publication number : **0 354 369 B1**

(12) # EUROPEAN PATENT SPECIFICATION

(45) Date of publication of patent specification :
26.07.95 Bulletin 95/30

(51) Int. Cl.⁶ : **G01J 5/20, H05K 1/16,**
// **G08B13/18**

(21) Application number : **89112731.8**

(22) Date of filing : **12.07.89**

(54) Infrared detector.

(30) Priority : **12.08.88 US 231797**

(43) Date of publication of application :
**14.02.90 Bulletin 90/07**

(45) Publication of the grant of the patent :
**26.07.95 Bulletin 95/30**

(84) Designated Contracting States :
**DE FR GB IT**

(56) References cited :
EP-A- 0 272 731
US-A- 4 142 207
US-A- 4 754 139
INFRARED PHYSICS, vol. 24, no. 1, 1984,
pages 57-64; K.C. LIDDIARD: "Thin-film resist-
ance bolometer IR detectors"
INFRARED PHYSICS, vol. 26, no. 1, 1986,
pages 43-49; K.C. LIDDIARD: "Thin-film resist-
ance bolometers-II"
INTERNATIONAL CONFERENCE ON SOLID-
STATE SENSORS AND ACTUATORS, 1985,
pages 132-135, IEEE, New York, US; I.H. CHOI
et al.: "A linear thermopile infrared detector
array with on-chip multiplexing"

(56) References cited :
APPLIED OPTICS, vol. 23, no. 6, March 1984,
pages 910-914, New York, US; P.M. DOWNEY
et al.: "Monolithic silicon bolometers"
INTERNATIONAL ELECTRON DEVICES MEET-
ING, Washington, D.C., 1st - 4th December
1985, pages 436-439, IEEE, New York, US; H.
ITO et al.: "a-Si:H TFT array driven linear
image sensor with capacitance coupling iso-
lation structure"
PATENT ABSTRACTS OF JAPAN, vol. 12, no.
314 (E-649)[3161], 25th August 1988; & JP-A-63
78 581 (FUJITSU) 08-04-1988

(73) Proprietor : **TEXAS INSTRUMENTS
INCORPORATED**
**13500 North Central Expressway**
**Dallas Texas 75265 (US)**

(72) Inventor : **Hornbeck, Larry J.**
**Route 1, Box 162**
**Van Alstyne Texas 75095 (US)**

(74) Representative : **Leiser, Gottfried, Dipl.-Ing. et
al**
**Prinz & Partner,**
**Manzingerweg 7**
**D-81241 München (DE)**

## Description

BACKGROUND OF THE INVENTION

1. Field of the Invention.

The present invention relates to infrared-radiation detectors, and, more particularly, to an array of bolometers for detecting radiation in a spectral range, the array of bolometers being implemented as a monolithic integrated circuit.

2. Description of the Related Art.

United States patent 4,754,139 discloses a bolometer arrangement wherein sensing elements are widely spaced, continuity of receiving area being provided by virtue of radiation concentrators, together with readout circuitry formed on a substrate to which the sensing elements are mechanically and electrically connected.

Detection of infrared radiation emitted by warm bodies provides an important method for night vision (perception without visible light). Infrared detectors may be classified in various ways, such as scanning or staring arrays, cryogenic (typically liquid nitrogen temperatures) or uncooled detectors, 3-5 micron or 8-12 micron spectral sensitivity range, and photon or thermal detection mechanism. Cryogenic infrared detectors are typically made of small bandgap (about 0.1-0.2 eV) semiconductors such as HgCdTe and operate as photodiodes or photocapacitors by photon absorption to produce electron-hole pairs. For example, see U.S.Pat.No. 4,686,373 (Tew et al) which describes a hybrid system with HgCdTe photocapacitors glued to silicon signal processing circuitry.

Uncooled infrared detectors cannot make use of small bandgap semiconductors because the bandgap is only about $4kT$ at room temperature and dark current swamps any signal. Consequently, uncooled infrared detectors rely on other physical phenomena and are less sensitive than cryogenic detectors but do not require cooling apparatus or its energy consumption. For portable, low power applications where the greater detectivity of cryogenic detectors is not needed, the preferred choice is an uncooled thermal detector: infrared photons are absorbed and the resultant heating of the absorbing element is detected. The thermal detector is usually one of three types: (1) pyroelectric detector, (2) thermocouple, or (3) bolometer.

The pyroelectric detector uses a ferroelectric ceramic material (such as $BaSrTiO_3$) at operating temperatures (typically 0°C to 150°C) a little below its Curie temperature. The preferred ferroelectric materials have a large change in spontaneous dielectric polarization at operating temperatures, and the heating of the ferroelectric is detected by sensing the induced voltage created by the generation of charge across a capacitor with the ferroelectric as insulator. For example see U.S.Pat.Nos. 4,348,611 (Ruppel et al), 4142,207 (McCormack et al), and 4,379,232 (Hopper).

The pyroelectric detector is a hybrid approach that has problems when extended to large detector arrays (arrays of 256 by 256 pixels) due to ferroelectric material defects, contact defects, and bump bonding defects which imply low yields.

Thermocouples rely on the change in contact potential of a junction of dissimilar conductors with temperature; see for example G.Lahiji et al, A Monolithic Thermopile Detector Fabricated Using Integrated-Circuit Technology, 1980 IEEE IEDM Tech.Dig. 676 which uses bismuth-antimony or polysilicon-gold couples in monolithic arrays on silicon.

Bolometers typically rely on the temperature change of resistance of thermally isolated thin metal films or semiconductor films. The thin films may be fabricated on a suspended dielectric film in a silicon substrate and may be located adjacent to monolithic detection circuitry on the silicon substrate. The dielectric film is thermally isolated from the remainder of the silicon substrate by etching away the silicon from beneath the dielectric film so that it is suspended. See for example K.C.Liddiard, 24 Infrared Physics 57 (1984) and 26 Infrared Physics 43 (1986) which includes amorphous silicon films for resistance change with temperature plus abutting nickel films for infrared absorption and electrical contact.

Thermocouples and bolometers avoid the yield problem of the pyroelectric detectors because they can be monolithically fabricated on a silicon wafer along with the detection circuitry. However, thermocouples and bolometers have the problem of lower detectivities than pyroelectric detectors.

SUMMARY OF THE INVENTION

The present invention provides infrared radiation imagers in the form of a monolithic array of bolometers according to claim 1, allowing a high fill factor geometry together with high sensitivity resistance material. Preferred embodiments use doped, hydrogenated amorphous silicon (a-Si:H) coated with an infrared absorber as the resistance material and an architecture suspending the resistance material over silicon detection circuitry. Preferably, the distance between the suspended resistance material and the underlying reflective substrate is one-quarter of the wavelength of the center of the infrared spectral band and provides enhanced infrared absorption.

This overcomes the problems of the known uncooled thermal detectors by achieving detectivity comparable to pyroelectric detectors while retaining the monolithic fabrication advantages of bolometers.

BRIEF DESCRIPTION OF THE DRAWINGS

The drawings are schematic for clarity.

Figure 1 shows a block diagram of an infrared detector system which includes a first preferred embodiment bolometer array;

Figure 2 is a plan view of a first preferred embodiment array;

Figure 3 is a perspective view of a single bolometer of the first preferred embodiment array;

Figures 4a-b are cross sectional elevation views of a single bolometer of the first preferred embodiment array;

Figures 5a-b are plan views of a single bolometer of the first preferred embodiment array and a portion of the array;

Figure 6 illustrates a model for analysis of the operation of the first preferred embodiment;

Figure 7 shows theoretical absorption, reflection, and transmission curves;

Figures 8a-g are cross sectional elevation views of steps of a preferred embodiment method of fabrication; and

Figures 9a-e are plan views of further preferred embodiment single bolometers.

DESCRIPTION OF THE PREFERRED EMBODIMENTS

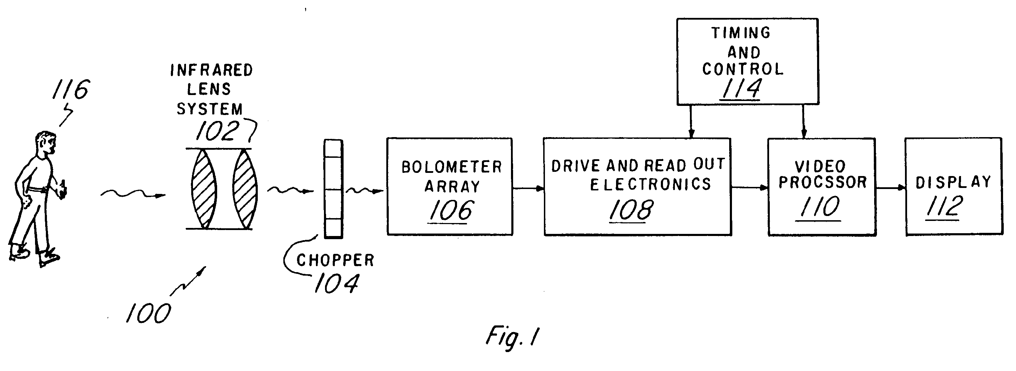

Figure 1 illustrates in schematic block diagram view an infrared imager system, generally denoted 100, which includes infrared lens system 102, mechanical chopper 104, bolometer array 106, drive and read out electronics 108 for array 106, video processor 110, display 112, and timing and control electronics 114. Lens system 102 images infrared radiation emitted by warm object 116 onto array 106. Chopper 104 may be a rotating disk with openings that periodically block and let pass the infrared radiation collected by lens system 102. Array 106 includes 64,536 bolometers arranged into 256 rows by 256 columns; each bolometer corresponds to a pixel in the image of warm body 116 plus surrounding scene in the field of view of lens system 102. Array 106 is housed in a stainless steel vacuum chamber with a infrared transparent window formed in one side. The window is positioned so that radiation from the scene with warm body 116 passes through the window onto array 106.

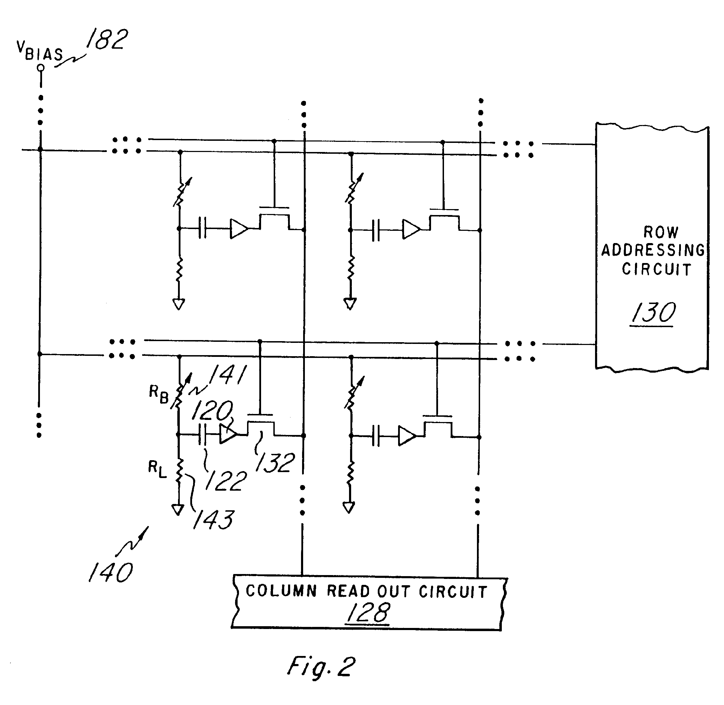

Figure 2 schematically illustrates in plan view a portion (four bolometers) of array 106 with thermally isolated resistor 141 that has a resistance $R_B$ that varies with temperature and is connected between grounded fixed load resistor 143 with resistance $R_L$ and fixed bias voltage $V_0$.

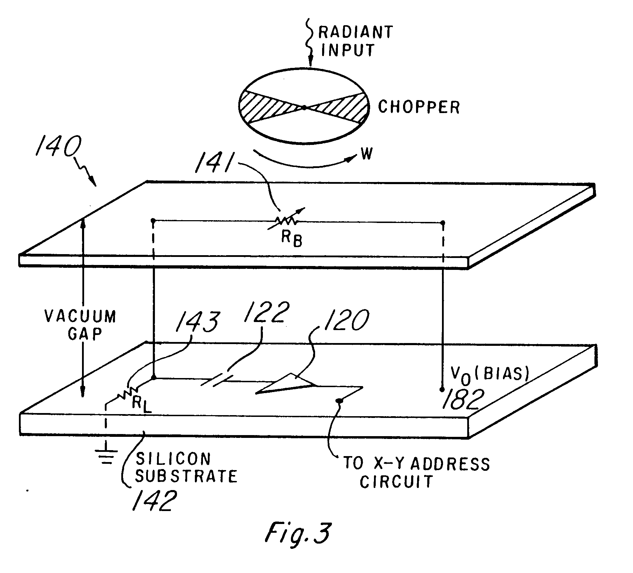

Figure 3 is a schematic perspective view of a single bolometer, generally denoted by reference numeral 140, from array 106. The operation of array 106 is as follows: The chopped scene including warm body 116 is imaged onto array 106 which causes each $R_B$ to fluctuate in value (with magnitude proportional to the temperature of the corresponding portion of the scene); the fluctuating value of $R_B$ yields an alternating voltage across load resistor 143 which is fed to buffer amplifier 120 through capacitor 122. The outputs of buffer amplifiers 120 are read in column read out circuit 128 with a row at a time selected by row addressing circuit 130 which turns on pass transistors 132 in one row at a time.

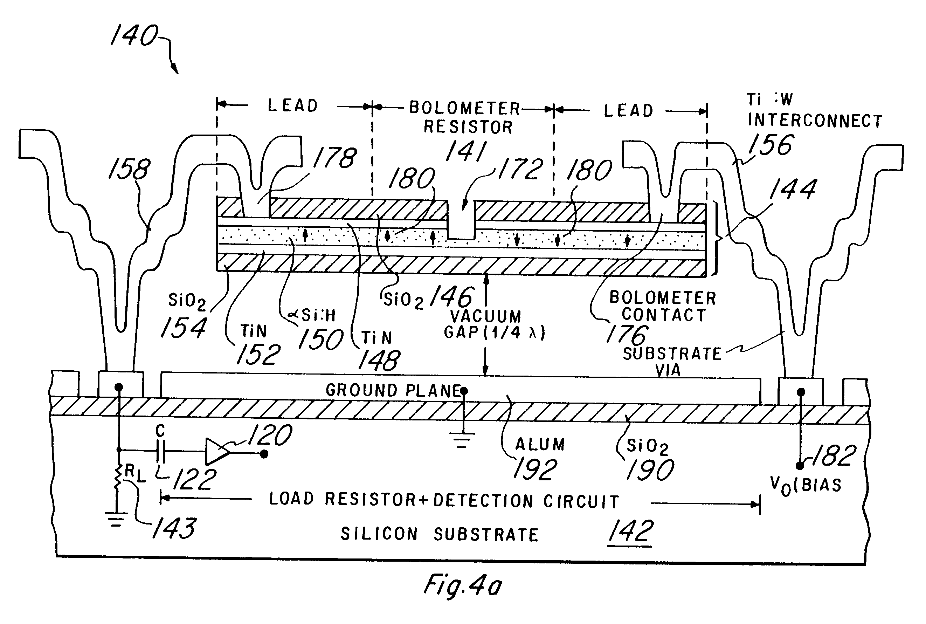

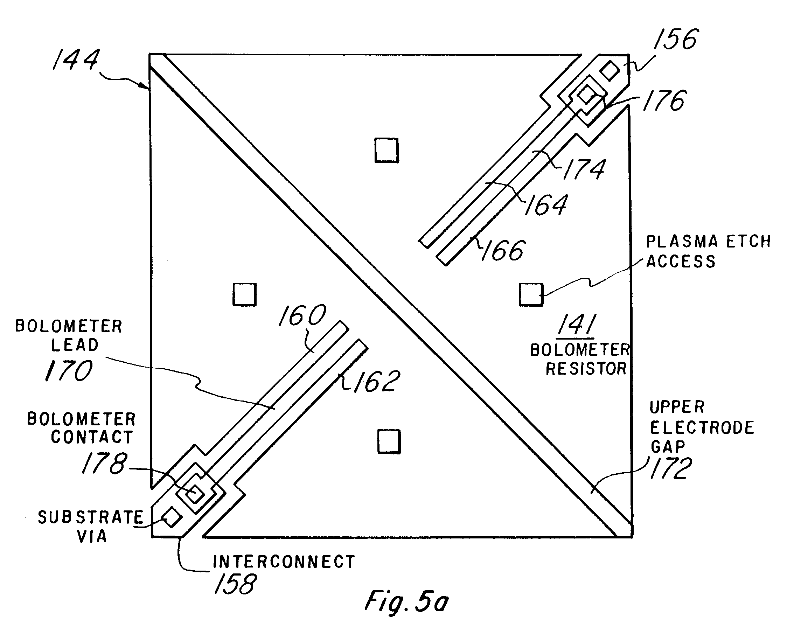

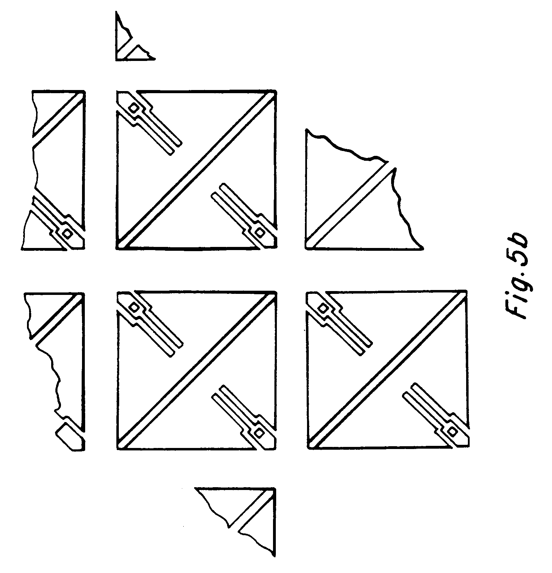

Figures 4a-b are schematic cross sectional elevation views of bolometer 140 and Figure 5a is a plan view; Figure 5b illustrates in plan view a portion of array 106 showing the arrangement of the individual bolometers. Bolometer 140 includes a 0,17 μm (1,700 Å) thick and 50 μm² stack 144 made of a top 0,05 μm (500 Å) layer of silicon dioxide (oxide) 146, a 0,01 μm (100 Å) layer of titanium nitride (TiN) 148, a 0,05 μm (500 Å) layer of hydrogenated amorphous silicon (a-Si:H) 150 doped with boron to a carrier concentration of $2 \times 10^{18}/cm^3$, another 0,01 μm (100 Å) layer of TiN 152, and a bottom 0,05 μm (500 Å) layer of oxide 154. Stack 144 is supported over substrate 142 by two titanium tungsten (Ti:W) interconnects 156 and 158 located at diagonally opposite corners of the stack 144. As shown in Figure 5a, stack 144 is square with two pairs of elongated openings 160, 162 and 164, 166 defining leads 170 and 174 between interconnects 156 and 158 and the remainder of stack 144 (resistor 141). Leads 170 and 174 are about 22 μm long and about 1.5 μm wide; this provides high thermal resistance. However, the heat loss from the main portion of stack 144 through leads 170 and 174 is more than an order of magnitude larger than the black-body radiation heat loss due to the temperature differential between resistor 141 and substrate 142. Upper electrode gap 172 separates upper oxide layer 146 and upper TiN layer 148 into two portions: one portion connected to interconnect 156 at contact 176 and the other portion connected to interconnect 158 at contact 178.

Vertical arrows 180 illustrate the direction of the direct current flow through a-Si:H 150. The current flow is from bias voltage supply 182 (5.8 volts) on substrate 142 through metal interconnect 156, into the half of TiN layer 148 on the contact 176 side of electrode gap 172, vertically down through a-Si:H 150 into TiN layer 152, vertically up through a-Si:H 150 into the half of TiN layer 148 on the contact 178 side of electrode gap 172, and lastly through interconnect 158 and load resistor 143 in substrate 142 to ground. The halves of TiN layer 148 and TiN layer 152 are highly conductive (about 800 $\mu\Omega$-cm resistivity) relative to a-Si:H 150 (about 1 M$\Omega$-cm resistivity) and may be considered equipotential surfaces. Thus resistor 141 is essentially two a-Si:H resistors in series, each a-Si:H resistor with a 0,05 $\mu$m (500 Å) length and a cross sectional shape of a 50 micron edge right triangle having a narrow notch extending from the right angle vertex nearly 90% of the way to the hypotenuse. The total resistance, $R_B$, is about 1.1 M$\Omega$ and $R_L$ is taken to be the same, so the total array 106 power dissipation in the resistors 141 and load resistors 143 is about 1 watt. The temperature coefficient of resistivity of a-Si:H 150 is about -0.072 per °C at a 300 K operating temperature of array 106.

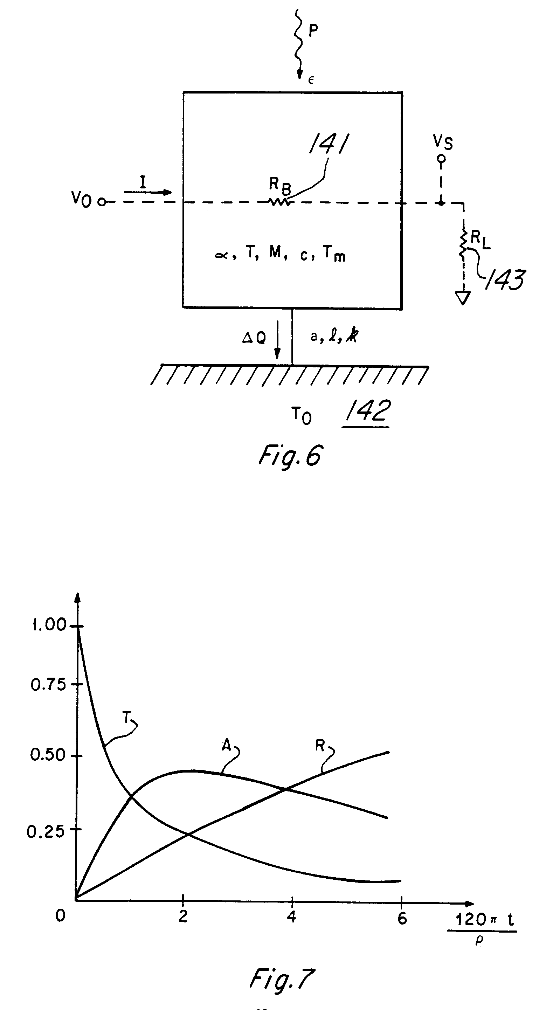

The thermal time constant for resistor 141 is smaller than the period of chopper 104 for good sensitivity; this is analyzed *infra*. The cooling of resistor 141 is primarily by heat conduction through leads 170 and 174 and then through supports 156 and 158 to silicon substrate 142. In particular, Figure 6 models the heat flow for resistor 141 with $P$ the incident infrared radiant power, $\varepsilon$ the fraction of the incident radiant power absorbed, $T$ the temperature of resistor 141, $T_m$ the mean temperature of resistor 141, $M$ the mass of resistor 141, $c$ the specific heat of resistor 141, $R_B$ the resistance of resistor 141, $k$ the thermal conductivity of the leads 170 and 174, $\alpha$ the cross sectional area of leads 170 and 174, $l$ the length of leads 170 and 174, $T_0$ the temperature of substrate 142, $V_0$ the applied dc voltage, $\alpha$ the temperature coefficient of resistance of resistor 141, $R_L$ the resistance of load resistor 143, and $V_S$ the signal voltage.

The power input to resistor 141 is the absorbed radiant power ($\varepsilon P$) plus the resistive heating power from $V_0$ ($i^2 R_B$), and the power loss from resistor 141 is primarily heat conduction down the leads 170 and 174 due to the thermal gradient ($k\alpha \frac{dT}{dx}$) along the leads. The gradient may be approximated by a linear temperature change along the leads, so the power loss is ($k(\alpha/l)(T - T_0)$). The net power input to resistor 141 causes a change in the temperature:

$$\varepsilon P + i^2 R_B - K(T - T_0) = C\frac{dT}{dt}$$

where $C = Mc$ is the thermal capacitance of $R_B$ and $K = k(\alpha/l)$ is the thermal conductance of leads 170 and 174. Note that both $i$ and $R_B$ depend upon $T$; however, a linear approximation to the temperature dependence of $R_B$ makes the differential equation tractable. In particular, presume the temperature coefficient of resistance $\alpha$ ($= \frac{1}{R_B}\frac{dR_B}{dT}$) is constant over the range of fluctuations of $T$. Typically, $T_0$ is about 300 K, $T_m$ is about 315-320 degrees K, and the fluctuation of T is much less than one K about $T_m$, so $\alpha$ constant is not a stringent presumption. For a-Si:H 150 $\alpha$ is about -0.072 at 320 K, hence $\alpha(T - T_m)$ is small and a first order approximation is sufficiently accurate:

$$i^2 R_B = \frac{V_0^2 R_m}{(R_L + R_m)^2}\left[1 + \alpha(T - T_m)(\frac{R_L - R_m}{R_L + R_m})\right]$$

where $R_m$ is the value of $R_B$ at temperature $T_m$, in other words, the mean resistance. The differential equation thus becomes:

$$C\frac{dT}{dt} + K(T - T_0) - \alpha(T - T_m)\frac{V_0^2 R_m}{(R_L + R_m)^2}\frac{R_L - R_m}{R_L + R_m}$$
$$= \varepsilon P + \frac{V_0^2 R_m}{(R_L + R_m)^2}$$

where $T$ and $P$ are the only functions of time, $t$. Rearranging the differential equation yields:

$$C \frac{d(T-T_m)}{dt} + (T - T_m) \left[ K - \alpha \frac{V_0^2 R_m}{(R_L + R_m)^2} \frac{R_L - R_m}{R_L + R_m} \right]$$
$$= \epsilon P + \frac{V_0^2 R_m}{(R_L + R_m)^2} - (T_m - T_0)K$$

where the second two terms on the right side of the equation are large (the heating power due to the dc current and the cooling power by conduction through the leads) and substantially cancel, and the variables ($T$ - $T_m$ and $P$) are small.

The radiant power input is chopped to improve signal-to-noise ratio. Thus the input radiant power is a square wave, and the resulting signal voltage can be computed from the foregoing equation to estimate the properties of bolometer array 106. The differential equation is easily solved by Fourier series expansion of $P$ and $T$ - $T_m$ and equating coefficients. That is, take $P$ to be given by

$$P(t) = P_0 \left[ \frac{1}{2} + \frac{2}{\pi} \sin(\omega t) + \frac{2}{3\pi} \sin(3\omega t) + \cdots \right]$$

and $T$ to be

$$T(t) = T_m + T_\omega \sin(\omega t - \phi) + T_{3\omega} \sin(3\omega t - \psi) + \cdots$$

where $\omega$ is the angular frequency of the chopping of the incident radiant power by chopper 104. The zero order coefficients yield:

$$0 = \epsilon P_0 \frac{1}{2} + \frac{V_0^2 R_m}{(R_L + R_m)^2} - (T_m - T_0)K$$

The first order coefficients yield:

$$T_\omega = \frac{\epsilon P_0 \frac{2}{\pi}}{\sqrt{\omega^2 C^2 + K_{eff}^2}}$$

with

$$K_{eff} = \left[ K - \alpha \frac{V_0^2 R_m}{(R_L + R_m)^2} \frac{R_L - R_m}{R_L + R_m} \right]$$

and

$$\phi = \arctan \frac{\omega C}{K_{eff}}$$

Note that neglecting $\epsilon P_0$ in the zero order equation and inserting the result in the expression for $K_{eff}$ yields:

$$K_{eff} = K \left[ 1 - \alpha(T_m - T_0) \frac{R_L - R_m}{R_L + R_m} \right]$$

so $K_{eff}$ is an effective heat conductance. Also, for chopping angular frequencies greater than $K_{eff}/C$ the amplitude of the fluctuations of $T$ will decrease approximately inversely to $\omega$.

The second order coefficients (and all other even-order coefficients) vanish, and for higher odd-order coefficients $T_{n\omega}$ falls off like $1/n^2$ because $P_{n\omega} = P_0 \frac{2}{n\pi}$ and the derivative contributes another $1/n$. Thus approximate $T$ by $T_m + T_\omega \sin(\omega t - \phi)$. This approximation, of course, is the exact solution for $P = P_0(\frac{1}{2} + \frac{2}{\pi} \sin \omega t)$ which are just the first two terms of the Fourier expansion of the square wave.

The output signal $V_S$ due to incident $P$ is computed by inserting the resulting $T$, and thus $R_B$, into the definition of $V_S$ as the fluctuation of the voltage across $R_L$:

$$V_S = V_0 \left[ \frac{R_L}{R_B + R_L} - \frac{R_L}{R_m + R_L} \right]$$

which gives a first order approximation of

$$V_S = -IR_m\alpha \frac{R_L}{R_L + R_m} T_\omega \sin(\omega t - \phi)$$

The response of the detector (the amplitude of $V_S$ divided by average incident power $P_0$) therefore increases with increasing $I$ (the dc current), $R_m$, $\alpha$, and decreases with increasing $C$ and $K_{eff}$ (which decreases $T_\omega$). Because the input impedance of amplifier 120 has to be larger than $R_B$, this puts an upper limit on $R_B$. Since any fluctuation of $I$ causes a noise signal, the current I through bolometer 140 has to be extremely constant. This, and the requirement that the temperature rise by Joule heating should be small limits the maximum current $I$. $K_{eff}$ has a lower limit in the sense that even with perfect thermal isolation of resistor 141, a temperature difference of resistor 141 from substrate 142 gives a net radiation flux from resistor 141 to substrate 142.

The choice of $R_L$ to maximize the sensitivity of bolometer 140 is easily computed from the definition of $V_S$ by noting that this is just maximizing

$$\frac{\partial V_S}{\partial R_B}$$

at $R_B = R_m$

as a function of $R_L$. This yields $R_L = R_m$. With this value of $R_L$, $K_{eff} = K$, $T_\omega = \varepsilon P_0 \frac{2}{\pi}/\sqrt{\omega^2 C^2 + K^2}$, and $V_S =$

$-\frac{1}{4} V_0 \alpha T_\omega \sin(\omega t - \phi)$ which is independent of $R_m$.

The temperature response to a step input incident radiant power may also be computed by solving the first order approximation differential equation: Presume $P = 0$ for $t < 0$ and $P = P_0$ for $t > 0$, then

$$T = T_\infty - (T_\infty - T_0)e^{-t/\tau}$$

with

$$\tau = \frac{C}{K_{eff}}$$

where $T_\infty$ is the asymptotic temperature and $T_0$ is the temperature prior to illumination. Thus the time constant of bolometer 140 is $\tau$.

To maximize the signal voltage amplitude (which is the responsivity multiplied by the incident power), bolometer 140 should have a minimum thermal capacitance $C$ and thermal conductance $K$ and maximum active resistor absorbing area $A$, temperature coefficient $\alpha$, and absorption $\varepsilon$. Bolometer 140 approaches these goals as follows. The thermal capacitance $C$ is minimized by making stack 144 of thin films and the thermal conductance $K$ is minimized by making leads 170 and 174 long and narrow. The active area $A$ is maximized by integrating array 106 on a single silicon substrate and locating the detection circuitry under resistor 141 to provide high fill factor in array 106. The temperature coefficient $\alpha$ for thermistor-type materials may be as high as 0.75 per degree K, but these materials are incompatible with silicon processing, and metal alloy films have coefficients of less than 0.01. So doped a-Si:H with a coefficient of about 0.07 provides a high coefficient together with silicon processing compatibility. Amorphous silicon is transparent to infrared radiation, so a high absorption $\varepsilon$ is achieved by having the TiN resistor electrodes 148 and 152 also provide the absorption. This is free carrier absorption and can be optimized by choice of resistivity, thickness, and gap from stack 144 to ground plane 192. The analysis is as follows.

First, consider infrared radiation normally incident on a metal film of thickness $t$ and resistivity $\rho$, and surrounded by air on both sides. The absorption $A$, reflection $R$, and transmission $T$ are illustrated in Figure 7 and computed from Maxwell's equations with the presumption that the index of refraction and the extinction coefficient of the metal are nearly equal, which is the case for wavelengths $\lambda \geq 10\mu m$. The absorption has a maximum at $12\pi t/\rho = 2$.

Next, consider the addition of a thick conducting layer parallel to the metal film and at a distance of $\lambda/4$ away. Then nearly 100% absorption is achieved at $120\pi t/\rho = 1$. This analysis appears in L.Hadley et al, 37 J.Optical Soc. Am. 451 (1947).

For bolometer 140 operation with 8 to 12 micron spectral sensitivity, the center wavelength is 10 microns so the distance from electrodes 148 and 152 to ground plane 192 is set at 2.5 microns (one quarter wavelength). The $120\pi t/\rho = 1$ requirement applies to the combination of layers 148 and 150 because the thickness of the transparent a-Si:H is small compared to the wavelength. Thus with a total thickness of 0,02 $\mu m$ (200 Å), the resistivity should be equal to $120\pi \times 2 \times 10^{-6}$, or about 750 $\mu\Omega$-cm, and this is about the resistivity of reactively sputtered TiN. For the 100 Å thick TiN electrodes 148 and 152 this translates to a sheet resistance of about 750 $\Omega/\square$. Note that other materials, including unannealed, sputtered silicides such as $MoSi_2$ and $WSi_2$, also are compatible with silicon processing and have appropriate resistivities. Because only the ratio of resistivity-to-thickness enters into the absorption analysis, the thickness of the electrodes 148 and 152 could be adjusted to compensate for the resistivity of the material used provided that the layer thickness is not so great as to significantly increase the thermal capacitance $C$ nor so small as to yield nonreproducible film properties. Also, oxide 146 and 154 provide a sealing of TiN 148 and 152 so that the TiN is never subjected to any plasma etches, oxidation or hydration effects which might affect its resistivity. Stable sheet resistances for the TiN layers are important in maintaining the optimum infrared absorption and uniformity of absorption.

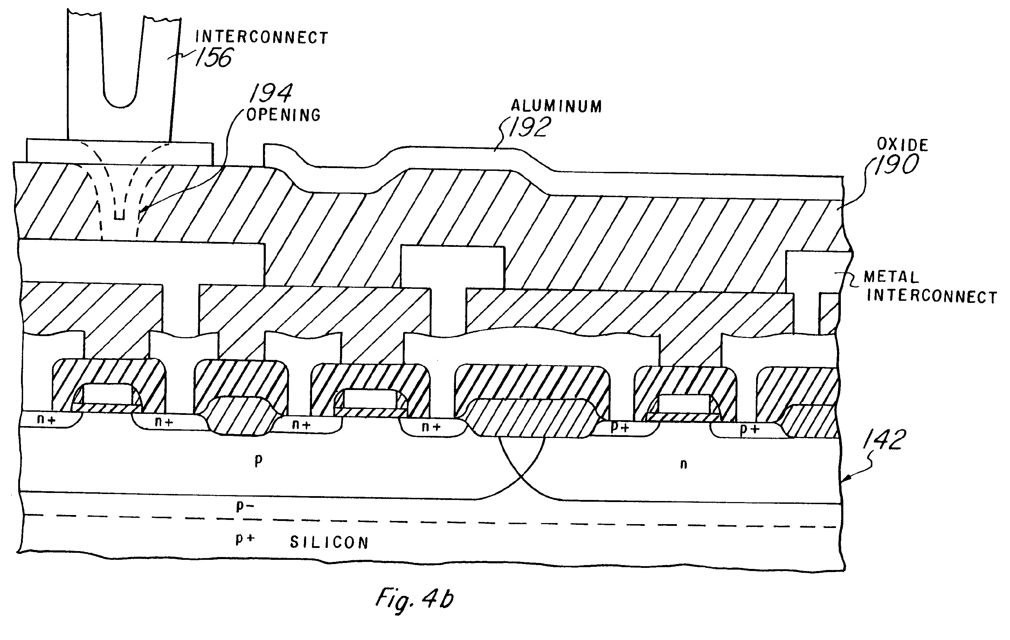

As shown in Figures 4a-b, oxide layer 190 covers and isolates load resistor $R_L$ and buffer amplifier 120 and the remainder of silicon substrate 142 from aluminum ground plane 192. The distance from aluminum ground plane 192 to the bottom of stack 144 is about 2.5 $\mu m$ for detection in the 8-12 $\mu m$ wavelength range; this distance from ground plane 192 to stack 144 is one quarter wavelength for the range's center frequency. Figure 4a schematically shows ground plane 192 as flat; whereas, Figure 4b illustrates some of the underlying circuitry (CMOS) in substrate 142 and indicates the slight (few hundredth of $\mu m$) unevenness of ground plane 192. TiN layers 148 and 152 provide the absorption of incident infrared radiation from the scene with warm body 116; amorphous silicon is transparent to infrared radiation. The quarter wavelength distance from ground plane 192 to stack 144 creates a quarter wavelength absorption filter for free carrier absorption in the thin, semi-transparent TiN 148 and 152 with an underlying quarter wavelength vacuum gap and ground plane reflector. The uneveness of ground plane 192 has minimal effect on the absorption. Note that use of a vacuum gap for the absorption filter limits the thermal capacitance of stack 144 as compared to the use of a dielectric in the gap.

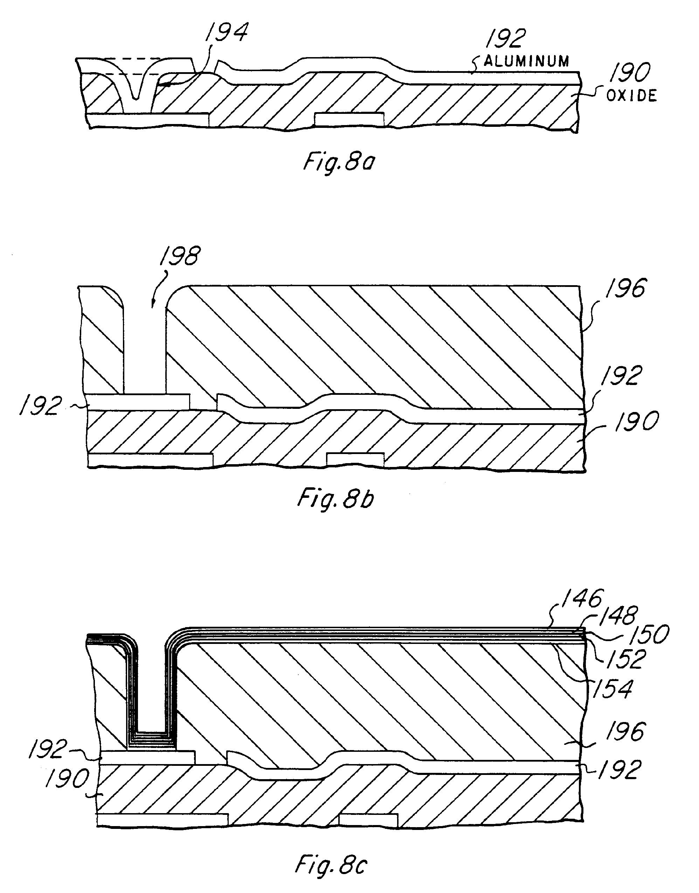

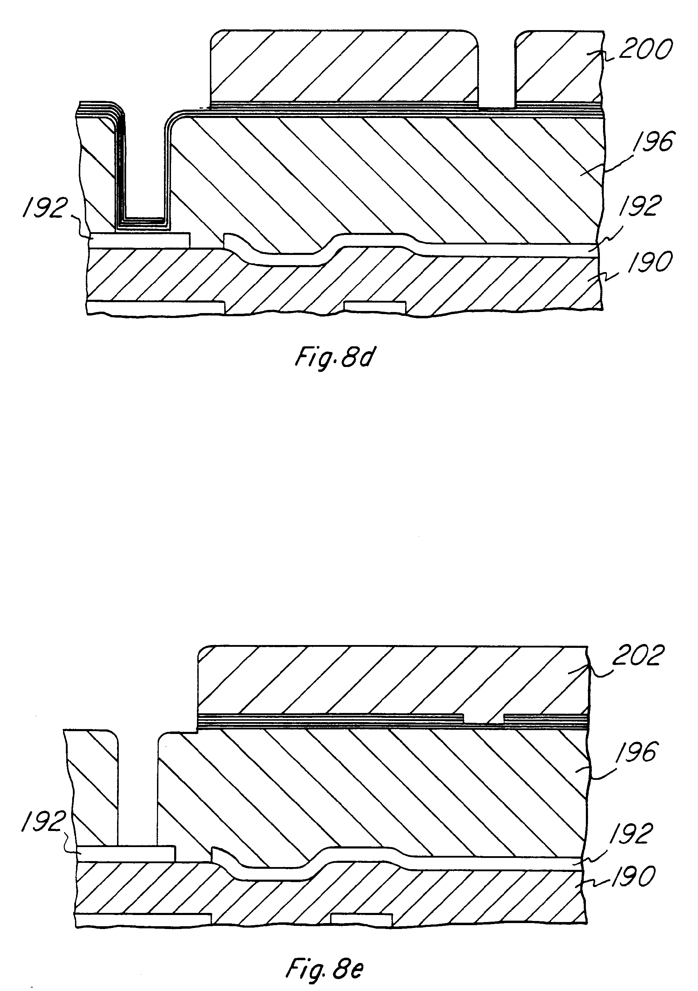

Consideration of the following description of a first preferred embodiment method of fabrication will provide further understanding of the first preferred embodiment bolometer and array characteristics and features. The first preferred embodiment method is illustrated in Figures 8a-g and includes the following steps.

(a) Form load resistors 143, buffer amplifiers 120, capacitors 122, addressing circuitry, metal interconnections and protective oxide 190 in silicon substrate 142 by standard CMOS processing. Photolithographically form circular openings 194 of diameter two microns in oxide layer 190 for contacts from interconnects 156 and 158 down to bias voltage 182 and load resistors 143 and capacitors 122. Sputter on 0,3 $\mu m$ (3,000 Å) thick aluminum 192 which fills the openings in oxide 190 as shown in dotted lines in Figure 4b, and pattern and etch aluminum 192 to isolate interconnect contacts from ground plane; see Figure 8a in which all of the circuitry below the oxide level 190 has been omitted for clarity.

(b) Spin on layer 196 of photoimageable polyimide to a thickness of 2.5 $\mu m$ on aluminum layer 192, and expose and develop a pattern of circular openings 198 about two $\mu m$ in diameter for interconnects 156 and 158. Next, bake to fully imidize polyimide 196. See Figure 8b in which the opening in oxide 190 has been suppressed for clarity. The interconnects 156 and 158 need not be located directly over openings 194, so the nonplanarity of aluminum 192 at openings 194 is not a problem.

(c) Sputter deposit *in situ* the layers that will form stack 144. In particular, place targets of oxide, titanium, and boron-doped silicon in a three target RF sputtering system. First sputter deposit a 0,05 $\mu m$ (500 Å) thick oxide layer 154 from the oxide target in an argon atmosphere, next sputter deposit a 0,01 $\mu m$ (100 Å) thick layer 152 of TiN from the titanium target in an argon/nitrogen atmosphere, then sputter deposit 0,05 $\mu m$ (500 Å) thick layer 150 of boron-doped hydrogenated amorphous silicon from the boron-doped silicon target in an argon/hydrogen atmosphere, then another 0,01 $\mu m$ (100 Å) thick TiN layer 148, and lastly another 0,05 $\mu m$ (500 Å) thick oxide layer 146. See Figure 8c, and note that polyimide 196 can withstand processing temperatures up to 300 degrees C which may be required during the amorphous silicon deposition to ensure a low density of gap states and correspondingly large conductivity activation energy.

(d) Spin on layer 200 of photoresist and expose and develop it to define stack 144 plus electrode gap 172 for each pixel. Plasma etch with the patterned photoresist 200 as etch mask in a plasma of $CF_4 + O_2$; this plasma etches oxide, TiN, and silicon and is stopped in the amorphous silicon layer by endpoint detection of SiF* species in the reaction products. See Figure 8d.

(e) Strip photoresist 200 and spin on second layer 202 of photoresist and expose and develop it to define stack 144 without electrode gap 172. Plasma etch with the patterned photoresist as etch mask in a plasma of $CF_4 + O_2$ to complete removal of the amorphous silicon, TiN, and oxide layers to form stack 144. This etch does not attack aluminum 192 and is stopped in polyimide 196 by endpoint detection of CO*; see Figure 8e. Also, forming leads 170 and 174 from the same stack 144 as the temperature dependent resistor simplifies the processing.

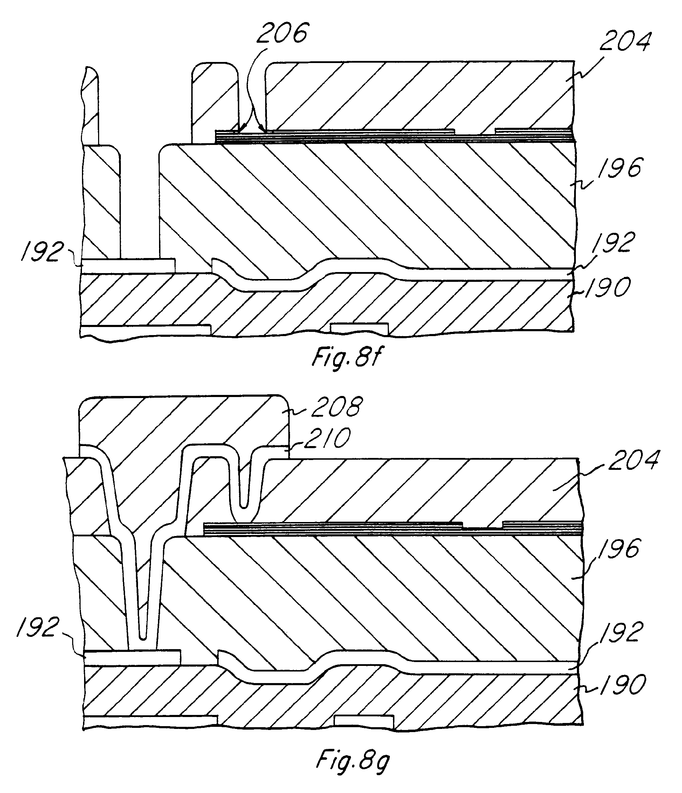

(f) Strip second photoresist 202 and spin on third layer 204 of photoresist and expose and develop it to define the contacts 176 and 178. A wet etch of oxide 146 in a 10% solution of HF and with patterned photoresist 204 as etch mask, stops on TiN 148. The wet etch is isotropic and undercuts photoresist 204; see undercuts 206 in Figure 8f. A light photoresist reflow sags photoresists 204 back to TiN 148 and eliminates the undercut overhang. Note that extreme selectivity in the etch is required because the TiN is only 0,01 $\mu$m (100 Å) thick, so if a sufficiently selective anisotropic plasma etch were used, then the undercut and consequent photoresist reflow would be avoided.

(g) Sputter deposit 0,5 $\mu$m (5,000 Å) layer 210 of Ti:W (an alloy of about 10% titanium to avoid the brittleness of pure tungsten) over patterned third photoresist 204. Spin on fourth layer 208 of photoresist and expose and develop it to define interconnects 156 and 158. Plasma etch the Ti:W in $SF_6$ with patterned fourth photoresist 208 as etch mask; this etch stops on photoresist 204. See Figure 8g.

(h) Spin on PMMA (polymethylmethacrylate) for protection and saw the silicon wafers containing the bolometer arrays into chips. Spin and spray the chips with chlorobenzene to remove the PMMA. Plasma ash the third and fourth photoresist layers 204 and 208 together with the polyimide layer 196. This completes the chips except for bonding and packaging. Note that in Figure 5a plasma etch access holes are shown in stack 144; these holes are etched through the oxide, TiN, and amorphous silicon layers when stack 144 is being formed and these holes reduces the amount of time required for the isotropic plasma ashing of the polyimide layer under stack 144.

Estimates on the performance of bolometer 140 with a chopping frequency of 30 Hz for chopper 104 can be computed as follows. First estimate the heat capacity $C$ of stack 144 (taken to be 50 $\mu$m$^2$) as $7.6 \times 10^{-10}$ joules/°C by estimating the volumetric specific heats of oxide, TiN, and a-Si:H to be 1.7, 2.34, and 1.72 joules/cm$^3$ °C, respectively. Next, estimate the thermal conductivity, $K$, of leads 170 plus 174 as $4.6 \times 10^{-7}$ watts/°C by estimating the thermal conductivity of oxide, TiN, and a-Si:H to be about 0, 0.2, and 0.84 watts/ °C, respectively, and the length and width of leads 170 and 174 to be 20 microns and 1 micron. Then inserting these values into $1/\sqrt{\omega^2 C^2 + K^2}$ yields:

$$T_\omega / \varepsilon P_0 \frac{2}{\pi} = 1.8 \times 10^6 \text{ °C/watt}$$

and the time constant $\tau = C/K = 1.7$ msec.

Presume a 1 degree C scene temperature difference in the 8-12 $\mu$m wavelength range (i.e., warm body 116 is 1 degree warmer than his surroundings and both have emissivities of 1.0 in 8-12 $\mu$m), an infrared lens system 102 with $f$/1 optics, and an irradiance level of $5.16 \times 10^{-5}$ watts/cm$^2$. Further presume $\varepsilon = 0.5$ (including the quarter wavelength filter with ground plane 192 would increase this to $\varepsilon \approx 1.0$), then the temperature fluctuation magnitude $T_\omega$ equals $0.76 \times 10^{-3}$ °C. Inserting this into the expression for the signal voltage amplitude *supra* yields a signal voltage amplitude of 78 $\mu$V (13 $\mu$V per volt of bias). This level of operation provides a total power dissipation of about 1 watt in array 106 and a mean temperature rise of about 17 °C ($T_m$ - $T_0$).

Noise estimates for bolometer 140 may be computed with the foregoing presumed parameters by following the 1984 Liddiard reference cited in the Background. This yields a noise equivalent power (NEP) from Johnson and thermal fluctuation noise of about $2.5 \times 10^{-11}$ watts. This translates to a noise equivalent temperature difference (NETD) of 0.02 K.

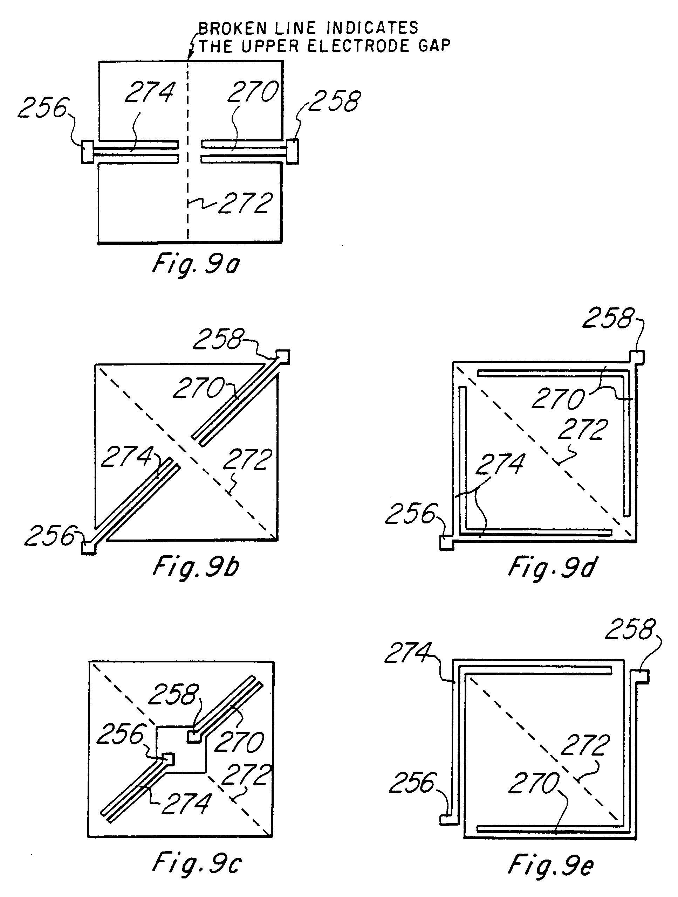

Further preferred embodiment bolometers and arrays are illustrated in plan views in Figures 9a-e; these plan views are analogs of Figure 5a for bolometer 140 and show the suspended resistor, leads, and interconnect to the underlying substrate containing the load resistor, signal voltage amplifier, and addressing. In particular, the upper electrode gap analogous to gap 172 of bolometer 140 is indicated by a broken line 272 in each of Figurés 9a-e, and the interconnects to the substrate analogous to interconnects 156 and 158 of bolometer 140 are indicated by 256 and 258. Similarly, the analogs of leads 170 and 174 are indicated by 270 and 274; note that in the preferred embodiment of Figure 9d the leads are bifurcated.

## MODIFICATIONS AND ADVANTAGES

Various modifications of the preferred embodiment devices and methods may be made while retaining features such as a temperature dependent resistor suspended over related processing circuitry for a high fill factor and avoidance of resistor edge passivation, a temperature dependent resistor made of a radiation absorbing material on a transparent high temperature coefficient material, a quarter wavelength filter absorber, and *in situ* deposition of resistor materials for uniform and reproducible resistors.

For example, the dimensions, shapes, and materials of the stack forming the temperature dependent resistor may be varied, although the absorption efficiency depends unpon the sheet resistance and processing-compatible materials are needed for manufacturability; the contact arrangement for the temperature dependent resistor could be varied such as one top contact and one bottom contact so the electrode gap would not be needed, or two bottom contacts; the passivation layer (oxide 146 and 154 in preferred embodiment 140) on the temperature dependent resistor contacts could be omitted and thereby lower the thermal capacitance; the edges of the temperature dependent resistor could be passivated to limit surface leakage (such as by oxide deposition after step (e) in the first preferred embodiment method); the air bridge interconnects 156 and 158 of bolometer 140 could be replaced by direct interconnect metal if the temperature dependent resistor is insulated to avoid the interconnects shorting out the top and bottom contacts; and the amorphous silicon resistive layer 150 could be heavily doped adjacent to the titanium nitride layers 148 and 152 in order to lower specific contact resistance and contact noise, of course the thickness of the high resistivity amorphous silicon will remain constant.

The invention provides the advantage high fill factor arrays.

## Claims

1. An array of bolometers (140) for detecting radiation in a spectral range, the array of bolometers being implemented as a monolithic integrated circuit which comprises:
   an array of resistors (141), each of said resistors (141) being spaced from a surface of a substrate (142) and oriented to receive radiation, said substrate (142) carrying read-out circuitry (128) for the bolometers (140),
   characterized in that each resistor (141) is located over and electrically connected to a set of read-out circuit elements (120, 122, 143) formed adjacent said surface, the resistor (141) and the read out circuit elements (120, 122, 143) together forming a bolometer (140) of the array (106).

2. The array of claim 1 further comprising a chopper (104) for the radiation received by said resistors (141).

3. The array of claim 1 or claim 2, wherein each of said resistors (141) has leads (170, 174) and said resistor plus leads (170, 174) are formed from a stack (144) including a first conductive layer (148), a resistive layer (150), and a second conductive layer (152) with said second conductive layer (152) the closest layer to said surface.

4. The array of claim 3, wherein:
   a) each of said resistors (141) is mechanically connected to said surface by connections (156, 158) that attach to said leads (170, 174) on said first conductive layer (148); and
   b) said stack (144) is supported by said connections.

5. The array of claim 3 or claim 4, wherein the fist conductive layer (148) is split into two regions which form two terminals of the resistor (141).

6. The array of claim 3, claim 4 or claim 5, wherein in a bolometer (140) thereof the distance from said second conductive layer (152) to said surface is about one quarter of the wavelength of the centre of the spectral range.

7. The array of claim 6, wherein:
   a) said second conductive layer (152) has a passivation layer (154);
   b) said surface is reflective; and
   c) the space between said surface and said passivation layer (154) is evacuated.

8. The array of claim 6 or 7, wherein the sheet resistance of said first and second conductive layers (148, 152) provides at least 50 % absorbtion in the spectral band.

9. The array of any of claims 3 to 8, wherein:
   a) said stack (144) includes a first passivation layer (146) on said first conductive layer (148) and a second passivation layer (154) on said second conductive layer (152);
   b) said first and second passivation layers (146, 154) are silicon dioxide;
   c) said first and the second conductive layers (148, 152) are titanium nitride; and
   d) said resistive layer (150) is amorphous silicon.

10. The array of any of claims 3 to 9, wherein said layer (150) of resistive material has higher conductivity in regions adjacent said first layer (148) and said second layer (152).

11. The array of any of claims 3 to 10 and further comprising a third layer (192) of conducting material, said third layer (192) being parallel to and spaced from said second layer (152) a distance equal to about one quarter of the wavelength of the centre of said spectral range.

**Patentansprüche**

1. Matrix aus Bolometern (140) für die Erfassung von Strahlung in einem Spektralbereich, wobei die Matrix aus Bolometern als monolithische integrierte Schaltung ausgeführt ist, die enthält: eine Matrix aus Widerständen (141), wobei jeder der Widerstände (141) einen Abstand von einer Fläche eines Substrats (142) hat und zum Empfangen von Strahlung ausgerichtet ist, wobei das Substrat (142) eine Leseschaltung (128) für die Bolometer (140) trägt, dadurch gekennzeichnet, daß jeder Widerstand (141) über eine angrenzend an die Fläche gebildeten Leseschaltungselementen (120, 122, 143) in elektrischer Verbindung mit diesen angebracht ist, wobei der Widerstand (141) und die Leseschaltungselemente (120, 122, 143) zusammen ein Bolometer (140) der Matrix (106) bilden.

2. Matrix nach Anspruch 1, ferner enthaltend einen Zerhacker (104) für die von den Widerständen (141) empfangene Strahlung.

3. Matrix nach Anspruch 1 oder Anspruch 2, bei welcher jeder der Widerstände (141) Leiter (170, 174) aufweist und der Widerstand mit den Leitern (170, 174) aus einem Stapel (144) gebildet ist, der eine erste leitende Schicht (148), eine widerstandsbehaftete Schicht (150) und eine zweite leitende Schicht (152) enthält, wobei die zweite leitende Schicht (152) die der Oberfläche am nächsten liegende Schicht ist.

4. Matrix nach Anspruch 3, bei welcher:
   a) jeder der Widerstände (141) mechanisch mit der Oberfläche durch Verbindungen (156, 158) verbunden ist, die an den Leitern (170, 174) auf der ersten leitenden Schicht (148) befestigt sind; und
   b) der Stapel (144) von den Verbindungen gehalten ist.

5. Matrix nach Anspruch 3 oder Anspruch 4, bei welcher die erste leitende Schicht (148) in zwei Bereiche geteilt ist, die zwei Anschlüsse des Widerstandes (141) bilden.

6. Matrix nach Anspruch 3, Anspruch 4 oder Anspruch 5, bei welcher in einem daraus gebildeten Bolometer (140) der Abstand zwischen der zweiten leitenden Schicht (152) und der Oberfläche etwa ein Viertel der Wellenlänge der Mitte des Spektralbereichs beträgt.

7. Matrix nach Anspruch 6, bei welcher:
   a) die zweite leitende Schicht (152) mit einer Passivierungsschicht (154) versehen ist;
   b) die Oberfläche reflektierend ist; und
   c) der Abstand zwischen der Oberfläche und der Passivierungsschicht (154) evakuiert ist.

8. Matrix nach Anspruch 6 oder 7, bei welcher der Flächenwiderstand der ersten und der zweiten leitenden Schicht (148, 152) in dem Spektralband eine Absorption von wenigstens 50 % ergibt.

9. Matrix nach einem der Ansprüche 3 bis 8, bei welcher:
   a) der Stapel (144) eine erste Passivierungsschicht (146) auf der ersten leitenden Schicht (148) und eine zweite Passivierungsschicht (154) auf der zweiten leitenden Schicht (152) enthält;
   b) die erste und die zweite Passivierungsschicht (146, 154) aus Siliciumdioxid bestehen;
   c) die erste und die zweite leitende Schicht (148, 152) aus Titaniumnitrid bestehen; und
   d) die widerstandsbehaftete Schicht (150) aus amorphem Silicium besteht.

10. Matrix nach einem der Ansprüche 3 bis 9, bei welcher die Schicht (150) aus widerstandsbehaftetem Material in Bereichen angrenzend an die erste Schicht (148) und die zweite Schicht (152) eine höhere Leitfähigkeit hat.

11. Matrix nach einem der Ansprüche 3 bis 10, ferner enthaltend eine dritte Schicht (192) aus leitendem Material, wobei die dritte Schicht (192) parallel und in einem Abstand von der zweiten Schicht (152) verläuft, der etwa gleich einem Viertel der Wellenlänge der Mitte des Spektralbereichs beträgt.

**Revendications**

1. Réseau de bolomètres (140) pour détecter une radiation dans un domaine spectral, le réseau de bolomètres étant formé sous la forme d'un circuit intégré monolithique qui comporte : un réseau de résistances (141), chacune desdites résistances (141) étant espacée d'une surface d'un substrat (142) et orientée pour recevoir une radiation, ledit substrat (142) supportant un circuit de lecture (128) pour les bolomètres (140), caractérisé en ce que chaque résistance (141) est située sur et électriquement reliée à un ensemble d'éléments de circuit de lecture (120,122,143) adjacent à ladite surface, la résistance (141) et les éléments de circuit de lecture (120,122, 143) formant ensemble un bolomètre (141) du réseau (106).

2. Réseau selon la revendication 1, comportant de plus un hacheur (104) pour la radiation reçue par lesdites résistances (141).

3. Réseau selon l'une des revendications 1 et 2, dans lequel chacune desdites résistances (141) comporte des conducteurs (170,174) et lesdits conducteurs positif de résistance (170,174) sont formés à partir d'une pile (144) comportant une première couche conductrice (148), une couche résistive (150) et une deuxième couche conductrice (152), ladite deuxième couche conductrice (152) étant la couche la plus proche de ladite surface.

4. Réseau selon la revendication 3, dans lequel:
   (a) chacune desdites résistances (141) est mécaniquement connectée à ladite surface par des connexions (156,158) qui sont fixées auxdits conducteurs (170,174) sur ladite première couche conductrice (148); et
   (b) ladite pile (144) est supportée par lesdites connexions.

5. Réseau selon l'une des revendications 3 et 4, dans lequel la première couche conductrice (148) est séparée en deux régions qui forment deux bornes de la résistance (141).

6. Réseau selon l'une des revendications 3,4 et 5, dans lequel dans un bolomètre (140) de ce réseau la distance entre ladite deuxième couche conductrice (152) et ladite surface est d'environ un quart de la longueur d'onde du centre du domaine spectral.

7. Réseau selon la revendication 6, dans lequel:
   (a) ladite deuxième couche conductrice (152) comporte une couche de passivation (154) :
   (b) ladite surface est réfléchissante ; et
   (c) l'espace entre ladite surface et ladite couche de passivation (154) est un espace de vide.

8. Réseau selon l'une des revendications 6 et 7, dans lequel la résistance de couche desdites première et deuxième couches conductrices (148,152) fournissent au moins 50% de l'absorption dans la bande spectrale.

9. Réseau selon l'une quelconque des revendications 3 à 8, dans lequel :
   (a) ladite pile (144) comporte une première couche de passivation (146) sur ladite première couche conductrice (148) et une deuxième couche de passivation (154) sur ladite deuxième couche conductrice (152);
   (b) lesdites première et deuxième couches de passivation (146,154) comportent du dioxyde de silicium;
   (c) lesdites première et deuxième couches conductrices (148,152) comportent du nitrure de titane ; et
   (d) ladite couche résistive (150) comporte du silicium amorphe.

10. Réseau selon l'une quelconque des revendications 3 à 9, dans lequel ladite couche (150) de matériau résistif comporte une conductivité supérieure dans des régions adjacentes à ladite première couche (148) et à ladite deuxième couche (152).

11. Réseau selon l'une quelconque des revendications 3 à 10, comportant de plus une troisième couche (192) de matériau conducteur, ladite troisième couche (192) étant parallèle à ladite deuxième couche (152) et espacée de celle-ci d'une distance égale à environ de un quart de la longueur d'onde du centre dudit domaine spectral.

Fig. 1

EP 0 354 369 B1

Fig.2

RADIANT INPUT

CHOPPER

W

140

141

$R_B$

VACUUM GAP

143 122 120

$V_0$ (BIAS)

$R_L$

182

SILICON SUBSTRATE

TO X-Y ADDRESS CIRCUIT

142

Fig. 3

Fig.4a

Fig. 4b

OXIDE 190
METAL INTERCONNECT
142
ALUMINUM 192
INTERCONNECT 156
194 OPENING

SILICON

144

156

176

174

164

166

PLASMA ETCH ACCESS

141 BOLOMETER RESISTOR

160

162

BOLOMETER LEAD 170

BOLOMETER CONTACT 178

UPPER ELECTRODE GAP 172

SUBSTRATE VIA

INTERCONNECT 158

Fig. 5a

EP 0 354 369 B1

Fig. 5b

Fig.6

Fig.7

Fig. 8a

Fig. 8b

Fig. 8c

Fig. 8d

Fig. 8e

Fig.8f

Fig.8g

BROKEN LINE INDICATES
THE UPPER ELECTRODE GAP

Fig. 9a

Fig. 9b

Fig. 9d

Fig. 9c

Fig. 9e